Europäisches Patentamt

European Patent Office

Office européen des brevets

(11) Veröffentlichungsnummer: **0 087 152**
**A2**

(12) # EUROPÄISCHE PATENTANMELDUNG

(21) Anmeldenummer: 83101650.6

(22) Anmeldetag: 21.02.83

(51) Int. Cl.³: **H 01 J 37/244**
**H 01 J 37/26, H 01 J 37/05**

(30) Priorität: 22.02.82 DE 3206309

(43) Veröffentlichungstag der Anmeldung:
31.08.83 Patentblatt 83/35

(84) Benannte Vertragsstaaten:
DE FR GB NL

(71) Anmelder: SIEMENS AKTIENGESELLSCHAFT
Berlin und München Wittelsbacherplatz 2
D-8000 München 2(DE)

(72) Erfinder: Lischke, Burkhard, Prof.Dr.Ing.
In der Heuluss 13
D-8000 München 82(DE)

(72) Erfinder: Plies, Erich, Dr.rer.nat.
Deisenhofener Strasse 79c
D-8000 München 90(DE)

(72) Erfinder: Schmitt, Reinhold, Dipl.-Ing.
Tucholsky Strasse 18
D-8000 München 83(DE)

(72) Erfinder: Frosien, Jürgen, Dr.Ing.
An der Ottosäule 18
D-8012 Ottobrunn(DE)

(54) Sekundärelektronen-Spektrometer und Verfahren zu seinem Betrieb.

(57) Bei einem Sekundärelektronen-Spektrometer für Elektronenstrahlgeräte sollen die elektrischen Felder von Sekundärelektronen-Spektrometer und Sekundärelektronen-Detektor praktisch vollständig gegen die Umgebung abgeschirmt sein. Es wird ein Sekundärelektronen-Spektrometer für Elektronenstrahlgeräte angegeben, welches mit dem Detektor (DT) zu einer nach außen hin streufeldfreien Einheit zusammengefaßt ist. Das Energiefilter (EF) und die Vorrichtung zur Erzeugung eines Ablenkfeldes für die Sekundärelektronen sind optisch dicht aufgebaut. Das Absaugfeld für die Sekundärelektronen hinter dem Energiefilter (EF) ist durch einen spannungsführenden Detektor ($E_3$), eine Rohrelektrode ($E_4$) und eine verschiebbare Gegenelektrode (GE) bestimmt. Hochenergetische Rückstreu-Elektronen (RE) können störungsfrei passieren.

FIG 2

EP 0 087 152 A2

SIEMENS AKTIENGESELLSCHAFT    Unser Zeichen

Berlin und München            VPA 82 P 1 1 1 5 E

0087152

Sekundärelektronen-Spektrometer und Verfahren zu seinem Betrieb.

Die Erfindung betrifft ein Sekundärelektronen-Spektrometer für Elektronenstrahlgeräte nach dem Oberbegriff des Anspruchs 1 und ein Verfahren zu seinem Betrieb.

Für die qualitative bzw. quantitative Messung von elektrischen Potentialen mit Elektronenstrahlen werden Sekundärelektronen-Spektrometer verwendet (H.P. Feuerbaum, 'Scanning Electron Microscopy', Chicago: IIT Research Institute, 1979, I, 285-296; D. Ranasinghe et al, 'Failure Analysis on Custom LSI Circuits Using a Modofied Scanning Electron Microscope to Display Voltage Waveforms', Microcircuit Engineering, 1981, Lausanne, (preprint). Mit Hilfe dieser Sekundärelektronen-Spektrometer werden Sekundärelektronen ausgefiltert, denen eine Information über das abzubildende bzw. zu messende Probenpotential aufgeprägt ist.

Bei der zitierten Anordnung nach H.P. Feuerbaum erweist sich als nachteilig, daß die elektrischen Felder von Sekundärelektronen-Spektrometer und Sekundärelektronen-Detektor nicht gegen die Umgebung vollständig abgeschirmt sind. Die Felder stellen eine elektronenoptische Anordnung zur Filterung und Abbildung der Sekundärelektronen auf die Oberfläche des Detektors dar. Da diese Felder jedoch in empfindlicher Weise von der Elektrodengeometrie der Umgebung abhängen, verhält sich diese zitierte Anordnung in jedem Elektronenrastermikroskop unterschiedlich und zeigt je nach Elektronenrastermikroskop unterschiedliche Spektrometerkennlinien, die sich auch noch zusätz-

My 1 Bla / 15.2.1982

lich ändern, wenn die Potentialverteilung in der Umgebung geändert wird. Als schädlich erweist sich außerdem, daß auch Sekundärelektronen zum Detektor gelangen, die mit der Abbildung bzw. Potentialmessung einer Probe nichts zu tun haben. So lösen z.B. an der . Probe rückgestreute, hochenergetische Elektronen weitere Sekundärelektronen an den Elektroden und sonstigen Oberflächen aus. Diese weiteren Sekundärelektronen können ebenfalls zum Detektor gelangen und das Signal verfälschen. .

Der vorliegenden Erfindung liegt die Aufgabe zugrunde, ein Sekundärelektronen-Spektrometer der eingangs genannten Art anzugeben, bei dem die elektrischen Felder von Sekundärelektronen-Spektrometer und Sekundärelektronen-Detektor praktisch vollständig gegen die Umgebung abgeschirmt sind.

Diese Aufgabe wird erfindungsgemäß durch ein Sekundärelektronen-Spektrometer der eingangs genannten Art gelöst, welches die kennzeichnenden Merkmale des Anspruchs 1 aufweist. Die Abschirmung der elektrischen Felder nach außen hat zur Folge, daß Sekundärelektronen-Spektrometer und Sekundärelektronen-Detektor eine elektronenoptische Einheit bilden, die durch störende elektrische Felder oder Elektroden von außen nicht mehr ungünstig beeinflußt werden kann.

Ausgestaltungen und Vorteile der Erfindung sind in den Unteransprüchen, der Beschreibung und der Zeichnung dargestellt. Bei einer erfindungsgemäßen Anordnung sind Sekundärelektronen-Spektrometer und Sekundärelektronen-Detektor zu einer kompakten, nach außen hin streufeldfreien Einheit zusammengefaßt. Eine erfindungsgemäße Anordnung ist optisch dicht aufgebaut, d.h. niederenergetische Fremdelektronen, welche von Streuung oder Diffu-

0087152

82 P 1 1 1 5 E

sion in der Säule des Elektronenrastermikroskops oder der Probenkammer herrühren, können nicht in das Sekundärelektronen-Spektrometer-Detektor-System gelangen. Damit werden niederenergetische Streuelektronen von außen ausgeschaltet und somit ein schädlicher Untergrund des Signals vermieden. Von der Probe rückgestreute, hochenergetische Elektronen werden ebenfalls bei einer erfindungsgemäßen Anordnung ausgeschaltet, so daß solche rückgestreuten, hochenergetischen Elektronen keine weiteren, das Signal störenden Sekundärelektronen auslösen können.

Ein Ausführungsbeispiel nach dem Stand der Technik und ein erfindungsgemäßes Ausführungsbeispiel sind in der Zeichnung dargestellt und werden im folgenden näher beschrieben.

Fig.1 zeigt eine Sekundärelektronen-Spektrometeranordnung nach dem Stand der Technik.

Fig.2 zeigen ein erfindungsgemäßes Sekundärelektronenmit 4 Spektrometer, und zwar zeigen

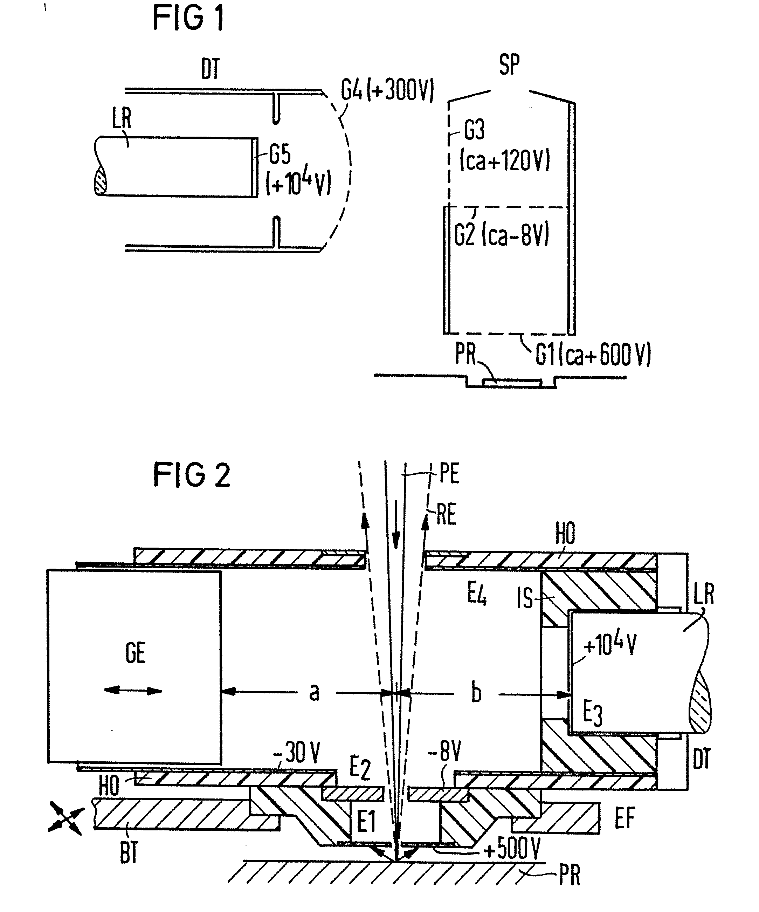

Fig.2 einen Schnitt von einer Seite parallel zur Achse der Rohrelektrode,

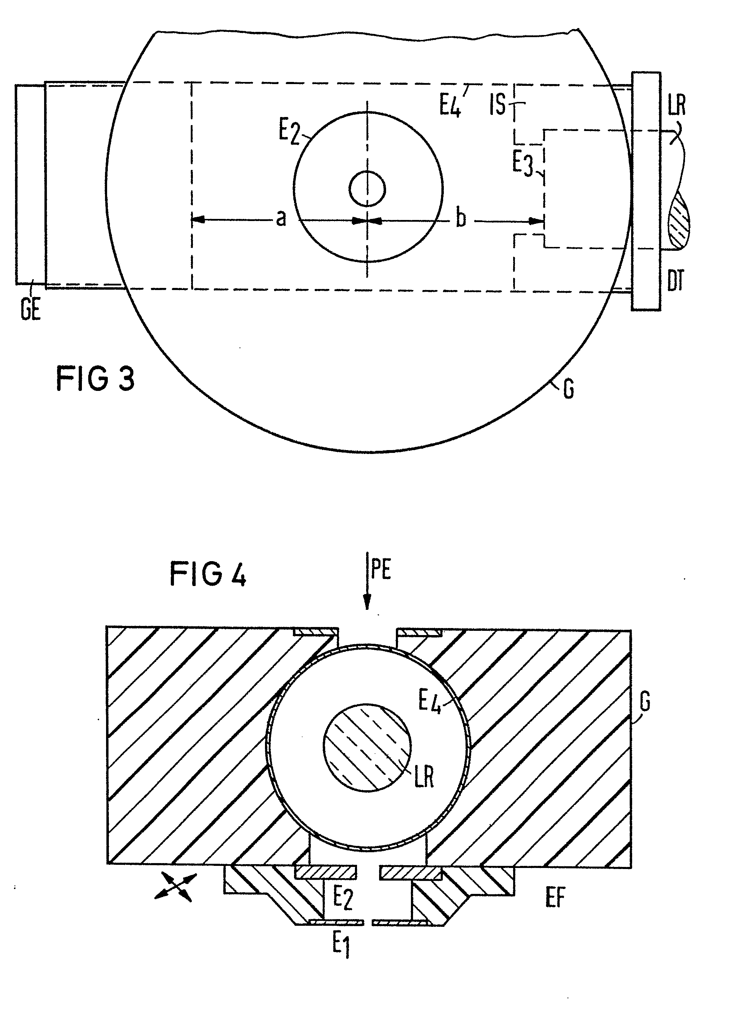

Fig.3 einen Schnitt senkrecht zur optische Achse,

Fig.4 einen Schnitt senkrecht zur Achse der Rohrelektrode.

Fig.1 zeigt eine Sekundärelektronen-Spektrometeranordnung nach dem Stand der Technik, wie sie z.B. in der zitierten Veröffentlichung von H.P. Feuerbaum dargestellt ist. Bei dieser konventionellen Sekundärelektronen-Spektrometeranordnung werden die Sekundärelektronen von der Probe PR mit Hilfe des Absaugnetzes G1 mittels Be-

und dann
schleunigung abgesaugt/ durch das Gegenfeldgitter G2 wieder abgebremst, wobei die niederenergetischen Sekundärelektronen durch das Gegenfeldgitter G2 ausgefiltert werden. Anschließend werden die Sekundärelektronen durch das Umlenkgitter G3 umgelenkt, sodann auf das Absauggitter G4 transferiert und schließlich auf den Szintillator G5 hin nochmals beschleunigt und dort nachgewiesen. Die Zahl der vom Sekundärelektronen-Detektor DT nachgewiesenen Sekundärelektronen ist bei festem Potential des Gegenfeldgitters G2 ein Maß für das elektrische Potential der Probe PR. Bei der gerade beschriebenen konventionellen Sekundärelektronen-Spektrometeranordnung umfaßt das Spektrometer SP also drei Elektroden G1, G2, G3, wobei das Absaugnetz G1 auf einem Potential von ca. +600 V, das Gegenfeldgitter G2 auf einem Potential von ca. -8 V und das Umlenkgitter G3 auf einem Potential von ca. +120 V liegen. Das Absauggitter G4 des Sekundärelektronen-Detektors DT liegt auf einem Potential von +300 V und der Szintillator G5 weist ein Potential von ca. $+10^4$ V auf. Bei der gerade beschriebenen konventionellen Sekundärelektronen-Spektrometeranordnung hängt das elektrische Feld zwischen dem Umlenkgitter G3 und dem Absauggitter G4 empfindlich von der Umgebung ab. Außerdem lösen von der Probe rückgestreute Elektronen unerwünschte Sekundärelektronen an den verschiedenen Gitterelektroden der konventionellen Sekundärelektronen-Spektrometeranordnung und an den Spektrometerwänden aus.

Die Fig.2 bis einschließlich 4 zeigen ein erfindungsgemäßes Sekundärelektronen-Spektrometer für Elektronenstrahlgeräte, bei welchem die gerade angeführten Nachteile der konventionellen Sekundärelektronen-Spektrometeranordnung nicht auftreten. Fig.2 zeigt einen Schnitt von einer Seite parallel zur Achse der Rohrelektrode. Das Absaugnetz G1 und das Gegenfeldgitter G2 der konventionellen Sekundärelektronen-Spektrometeranordnung sind durch ein Energiefilter EF ersetzt, wobei dieses Energiefilter EF im wesentlichen aus zwei Elektroden $E_1$ und $E_2$ besteht, welche sich auf einem gesonderten Blendentrieb BT befinden und zur Justierung relativ zum Primärelektronenstrahl PE verschoben werden können. Die Elektrode $E_1$ ist als Saugblende ausgeführt und liegt auf einem Potential von ca. +500 V. Die Elektrode $E_2$ ist als Bremsblende ausgeführt und liegt auf einem Potential von ca. -8 V. Durch das Energiefilter EF werden die an der Probe PR ausgelösten niederenergetischen Sekundärelektronen ausgefiltert. Das Absaugfeld nach dem Energiefilter EF wird bestimmt durch den spannungsführenden Szintillator $E_3$, einer Rohrelektrode $E_4$, in welcher sich der Szintillator $E_3$ zusammen mit dem Lichtleiter LR befindet, und einer verschiebbaren Gegenelektrode GE. Szintillator $E_3$ und Lichtleiter LR sind Bestandteile des Detektors DT. Der Szintillator $E_3$ befindet sich auf einem Potential von ca. $+10^4$ V und ist gegen die Rohrelektrode $E_4$ durch einen Isolator IS elektrisch isoliert. Die Rohrelektrode $E_4$ liegt auf einem Potential von ca. -30 V und ist teilweise von einem hochohmigen Material HO, welches z.B. aus Teflongraphit besteht, umgeben. Dieses hochohmige Material HO dient z.B. auch als Isolator zwischen dem Energiefilter EF und der Rohrelektrode $E_4$. Die Rohrelektrode $E_4$ ist für den Durchtritt des Primärelektronenstrahls PE durchbohrt. Auf diese Weise sind bei einem erfindungsgemäßen Sekundärelektronen-Spektrometer Spektrometer und Detektor DT zu einer streufeldfreien, kompakten Einheit zusammengefaßt. Das Umlenkgitter G3 und das Absauggitter G4, wie sie bei der konventionellen Sekundärelektronen-Spektrometeranordnung verwendet werden, entfallen bei einem erfindungsgemäßen Sekundärelektronen-Spektrometer. Eine Rohröffnung der Rohrelektrode $E_4$ ist von dem Szintillator $E_3$ zusammen mit dem Lichtleiter LR und dem Isolator IS verschlossen, die entgegengesetzte Rohröffnung der Rohrelektrode $E_4$ jenseits der Bohrung in der Rohrelektrode $E_4$ für den Primärelektronenstrahl PE ist von der Gegenelektrode GE verschlossen. Die Gegenelektrode GE hat zur Mitte des Primärelektronenstrahls PE den Abstand a. Der Szintillator $E_3$ hat zur Mitte des Primärelektronenstrahls PE auf der anderen Seite der Rohrelektrode $E_4$ einen Abstand b. Durch eine entsprechende Wahl der Abstände a und b können die Stärke und Inhomogenität des Ablenkfeldes für die Sekundärelektronen innerhalb der Rohrelektrode $E_4$ eingestellt werden. Da sich die Rohrelektrode $E_4$ auf negativem Potential befindet, können keine niederenergetischen Sekundärelektronen aus der Richtung, aus der der Primärelektronenstrahl PE einfällt, in den Sekundärelektronen-Spektrometerdetektor eindringen. An der Probe PR rückgestreute hochenergetische Elektronen RE werden entweder von den Blenden des Energiefilters EF zurückgehalten oder verlassen den Sekundärelektronen-Spektrometerdetektor durch die dem Energiefilter EF gegenüberliegende Bohrung in der Rohrelektrode $E_4$, da diese rückgestreuten Elektronen RE von dem Ablenkfeld innerhalb der Rohrelektrode $E_4$ wegen ihrer höheren Energie kaum beeinflußt werden. Das Energiefilter EF ist optisch dicht an die Rohrelektrode $E_4$ gekoppelt. Das Energiefilter EF befindet sich in unmittelbarer Nähe derjenigen Bohrung in der Rohrelektrode $E_4$ für den Primärelektronenstrahl PE, welche der Probe PR am nächsten liegt, und zwar zwischen dieser unteren Bohrung in der Rohrelektrode $E_4$ und der Probe PR.

Fig.3 zeigt einen Schnitt senkrecht zur optischen Achse.                    Die verschiebbare Gegenelektrode GE befindet sich auf demselben Potential wie die Rohrelektrode $E_4$ und weist zur Mitte des Primärelektronenstrahls PE einen Abstand a auf. Der Szintilla-

tor $E_3$ weist zur Mitte des Primärelektronenstrahls einen Abstand b auf. Wenn der Abstand b gemäß den oben genannten Gesichtspunkten festgelegt ist, wird die Gegenelektrode GE solange verschoben, bis das Signal der Sekundärelektronen im Detektor DT maximal ist. Der Sekundärelektronen-Spektrometerdetektor befindet sich in einem Gehäuse G.

Fig.4 zeigt einen Schnitt senkrecht zur Achse der Rohrelektrode. Die Elektroden $E_1$, $E_2$ des Energiefilters EF befinden sich auf einem gesonderten Blendentrieb BT und können zur Justierung relativ zum Primärelektronenstrahl PE verschoben werden. Der Lichtleiter LR des Detektors DT ist konzentrisch zur Rohrelektrode $E_4$ angeordnet. Der Sekundärelektronen-Spektrometerdetektor befindet sich in einem Gehäuse G. Das Energiefilter EF ist optisch dicht an die Rohrelektrode $E_4$ gekoppelt, so daß auch von der Probe PR her keine unerwünschten Rückstreuelektronen RE in den Spektrometerdetektor eintreten können.

9 Patentansprüche
4 Figuren

Patentansprüche:

1. Sekundärelektronen-Spektrometer für Elektronenstrahlgeräte, g e k e n n z e i c h n e t durch eine Zusammenfassung mit dem Detektor (DT) zu einer nach außen hin streufeldfreien Einheit.

2. Sekundärelektronen-Spektrometer nach Anspruch 1, g e k e n n z e i c h n e t durch einen optisch dichten Aufbau von Energiefilter (EF) und der Vorrichtung zur Erzeugung eines Ablenkfeldes für die Sekundärelektronen.

3. Sekundärelektronen-Spektrometer nach Anspruch 1 oder 2, g e k e n n z e i c h n e t durch eine störungsfreie Passage für hochenergetische Rückstreu-Elektronen (RE).

4. Sekundärelektronen-Spektrometer nach Anspruch 1 bis 3, dadurch g e k e n n z e i c h n e t , daß das Energiefilter (EF) für die Sekundärelektronen aus einer Saugelektrode ($E_1$) und einer Bremselektrode ($E_2$) besteht.

5. Sekundärelektronen-Spektrometer nach Anspruch 4, g e k e n n z e i c h n e t durch einen Blendentrieb (BT) zur Justierung der Saugelektrode ($E_1$) und der Bremselektrode ($E_2$).

6. Sekundärelektronen-Spektrometer nach Anspruch 1 bis 5, dadurch g e k e n n z e i c h n e t , daß das Absaugfeld für die Sekundärelektronen hinter dem Energiefilter (EF) durch einen spannungsführenden Detektor ($E_3$), eine Rohrelektrode ($E_4$) und eine verschiebbaren Gegenelektrode (GE) bestimmt ist.

7. Sekundärelektronen-Spektrometer nach Anspruch 6, dadurch g e k e n n z e i c h n e t , daß die Rohrelek-

trode ($E_4$) für den Durchtritt von Elektronen (PE; RE) durchbohrt ist.

8. Sekundärelektronen-Spektrometer nach Anspruch 6 oder 7, dadurch g e k e n n z e i c h n e t , daß sich die Rohr-elektrode ($E_4$) auf negativem Potential befindet.

9. Sekundärelektronen-Spektrometer nach Anspruch 4 bis 8, dadurch g e k e n n z e i c h n e t , daß das Energiefil-ter (EF) optisch dicht an die Rohrelektrode ($E_4$) gekoppelt ist.

10. Verfahren zum Betrieb eines Sekundärelektronen-Spektrometers nach Anspruch 6 bis 9, dadurch g e k e n n - z e i c h n e t , daß der Abstand (a; b) zwischen Szintil-lator ($E_3$) und Gegenelektrode (GE) so gewählt wird, daß der Sekundärelektronenstrom am Detektor (DT) maximal ist.

## FIG 1

DT

G4 (+300V)

LR

G5 (+10⁴V)

SP

G3 (ca+120V)

G2 (ca-8V)

PR

G1 (ca+600V)

## FIG 2

PE

RE

HO

E4

IS

LR

GE

+10⁴V

a

b

E3

-30V

E2

-8V

DT

HO

E1

EF

BT

+500V

PR

0087152

FIG 3

FIG 4